# EUROPEAN PATENT APPLICATION

(11) **EP 3 967 961 A1**
(43) Date of publication of application: **16.03.2022**
(21) Application number: 20196209.9
(22) Date of filing: 15.09.2020
(51) Int. Cl.: F28D 15/04, F28D 15/02, H01L 23/427

(54) **VAPOUR CHAMBER**

(71) Applicant: Nokia Technologies Oy, 02610 Espoo (FI)
(72) Inventor: JEFFERS, Nick, Wicklow, A63YH63 (IE); O'CONNEL, Diarmuid, Co. Kildare (IE); DAVIS, Ian, Co. Wicklow (IE); AGARWAL, Akshat, Co. Meath, C15TVF1 (IE); BURNS, Ollie, Co. Meath, A82E624 (IE)
(74) Representative: Swindell & Pearson Limited

(57) **Abstract**

According to examples of the disclosure there is provided a vapour chamber comprising one or more ducts extending between a condenser and an evaporator. Powder can be provided within the one or more ducts wherein the powder is configured to control flow of a working fluid through the one or more ducts.

## Description

### TECHNOLOGICAL FIELD

Examples of the disclosure relate to vapour chambers. Some relate to vapour chambers comprising one or more ducts for enabling flow of a working fluid.

### BACKGROUND

Devices such as devices can produce unwanted heat during use. It is beneficial to provide apparatus such as vapour chambers to enable this heat to be removed.

### BRIEF SUMMARY

According to various, but not necessarily all, examples of the disclosure, there is provided a vapour chamber comprising: one or more ducts extending between a condenser and an evaporator; and powder provided within the one or more ducts wherein the powder is configured to control flow of a working fluid through the one or more ducts.

The vapour chamber may comprise an evaporator at a first end of the one or more ducts.

The vapour chamber may comprise a condenser at a second end of the one or more ducts.

A grain size of the powder may be selected to control flow of the working fluid through the one or more ducts.

Different grain sizes of powder may be used at different positions within the one or more ducts to control flow of the working fluid through the one or more ducts.

A grain size of the powder within the one or more ducts may be configured to balance fluid resistance within the one or more ducts with capillary pressure within an evaporator.

The vapour chamber may comprise a plurality of ducts wherein powder is provided within the ducts and the plurality of ducts are configured to extend outward from an evaporator.

The powder may be provided within the one or more ducts so that the powder reaches an upper end of the one or more ducts. The powder may reach an upper end of the one or more ducts to enable the powder within the one or more ducts to be coupled to a condenser to enable working fluid to flow from the condenser to the powder in the one or more ducts.

The vapour chamber may comprise a first array of one or more ducts that is thermally coupled to a second array of one or more ducts.

The vapour chamber may comprise a first array of one of more ducts that is thermally isolated from a second array of one or more ducts.

The first array of one or more ducts may be configured to provide cooling for a first electronic component and the second array of one or more ducts is configured to provide cooling for a second electronic component.

According to various, but not necessarily all, examples of the disclosure, there is provided an electronic device comprising a vapour chamber as claimed in any preceding claim.

According to various, but not necessarily all, examples of the disclosure, there is provided a method of forming a vapour chamber comprising; forming one or more ducts configured to extend between a condenser and an evaporator; and providing powder within the one or more duct wherein the powder is configured to control flow of a working fluid through the one or more ducts.

The one or more ducts may be formed using an additive manufacturing process.

The powder may be provided up to an upper end of the one or more ducts.

The method may comprise positioning a condenser over the one or more ducts wherein the positioning is configured to enable working fluid to flow from the condenser layer into the powder in the one or more ducts.

### BRIEF DESCRIPTION

Some examples will now be described with reference to the accompanying drawings in which:
Fig. 1 shows an example vapour chamber;
Fig. 2 shows ducts for use in a vapour chamber;
Fig. 3 shows an exploded view of example vapour chamber;
Fig. 4 shows another exploded view of a vapour chamber;
Figs. 5A and 5B show another example vapour chamber; and
Fig. 6 shows an example method.

### DETAILED DESCRIPTION

Examples of the disclosure relate to vapour chambers 101. The vapour chambers 101 can be used for cooling components within electronic devices or any other suitable types of device.

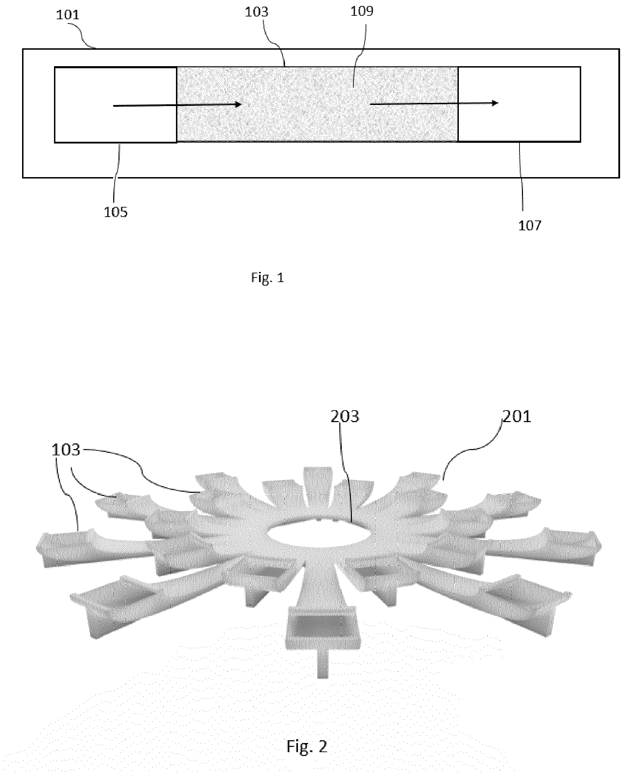

Fig. 1 schematically shows a cross section through a vapour chamber 101 according to examples of the disclosure.

The vapour chamber 101 comprises a duct 103 that extends between a condenser 105 and an evaporator 107. In the example shown in Fig. 1 the vapour chamber 101 comprises a single duct 103. It is to be appreciated that in other examples of the disclosure the vapour chamber 101 could comprise more than one duct 103.

The duct 103 can comprise any suitable material. The duct 103 can comprise a lightweight material. In some examples the duct 103 can comprise plastic or any other suitable material.

The duct 103 provides a channel for flow of a working fluid in the vapour chamber 101. The duct 103 can be configured to enable fluid in a liquid phase to flow from the condenser to 105 to the evaporator 107 as indicated by the arrows. In the example shown in Fig. 1 the condenser 105 is provided at a first end of the duct 103 and the evaporator 107 is provided at a second end of the duct 103 where the second end is an opposing end to the first end.

In the example shown in Fig. 1 the duct 103 has a regular cross section so that the duct 103 has the same diameter along the length of the duct 103. In other examples the duct 103 could have a variable diameter so that the duct 103 has different widths at different positions along the length of the duct 103. For instance, the duct 103 could be wider at the end closest to the condenser 105 than at the end closest to the evaporator 107.

In examples of the disclosure the duct 103 comprises powder 109. The powder 109 is provided within the duct 103 and is configured to control the flow of the working fluid through the duct 103. The powder 109 can fill the duct 103 so that the powder 109 extends through the duct 103 from the condenser 105 to the evaporator 107.

In some cases the powder 109 does not need to be printed or formed by any specialized process. The gaps between the powder 109 in the duct 103 provide a path for the working fluid. The powder 109 can comprise grains of plastic, ceramics, metals or any other suitable material or combinations of materials.

When the vapour chamber 101 is in use heat from a heat source causes a working fluid within the vapor chamber 101 to evaporate at the evaporator 107 and change phase from a liquid to a gas. The working fluid in the gas phase travels from the evaporator 107 through an internal volume of the vapor chamber 101 to the condenser 105. At the condenser 105 the comparatively cooler temperature causes the working fluid to condense and change phase from a gas to a liquid. As a result, heat is transferred from the evaporator 107 to the condenser 105. The working fluid in the liquid phase is then returned to the evaporator 107 though the powder 109 in the duct 103 as indicated by the arrows in Fig. 1. The powder 109 controls the flow of the working fluid through the duct 103 so as to balance the capillary pressure generated by the evaporation of the working fluid at the evaporator 107.

The powder 109 has a grain size that is selected so as to control the flow of the working fluid through the duct 103. The powder 109 has a grain size so as to enable the working fluid to travel through the duct 103 by wicking. The grain size of the powder 109 could be in the range of microns.

The grain size of the powder 109 within the duct 103 is configured to balance fluid resistance within the duct 103 with capillary pressure within the evaporator 107. This enables continuous flow of the working fluid within the vapour chamber 101 and prevents the evaporator 107 from drying out and overheating.

In some examples the grain size of the powder 109 within the duct 103 can be uniform or substantially uniform so that the powder 109 has the same grain size along the length of the duct 103. In other examples the powder 109 can have a variable grain size so that different grain sizes can be used in different positions along the length of the duct 103. The different grain sizes and the positions along the duct 103 at which the different grain sizes are used can be selected so as to control the flow of the working fluid through the duct 103.

In some examples the grain size of the powder 109 can be larger in the region of the duct 103 that is closer to the condenser 105 and smaller in the region of the duct 103 that is closer to the evaporator 107. In such examples the grain size decreases along the length of the duct 103. This causes an increase in the fluid resistance along the length of the duct 103. In such examples a higher fluid resistance is provided by the smaller grain size close to the evaporator 107 where the capillary pressure provided by the evaporation of the working fluid will be greater.

In the example shown in Fig. 1 the duct 103 is shown extending in a horizontal direction so that gravity does not need to be taken into account when determining the grain size of powder 109 to be used. In other examples the condenser 105 and the evaporator 107 could be provided on different vertical levels. In such examples the grain sizes of the powder 109 could be selected to take into account the effect of gravity.

Fig. 2 shows a plurality of ducts 103 that could be used in a vapour chamber 101 in examples of the disclosure. The ducts 103 are configured in an array 201.

The ducts 103 comprise a plurality of hollow channels that can be filled with powder 109 to allow for flow of a working fluid. The powder 109 is not shown in the example of Fig. 2.

In the example shown in Fig. 2 the plurality of ducts 103 are configured in an array 201 around an evaporator region 203. The evaporator region 203 is the region in which the evaporator 107 is to be located. The array 201 shown in Fig. 2 is configured so that all of the ducts 103 within the array 201 direct the working fluid to the same evaporator region. In other examples the ducts 103 can be configured so that different ducts 103 direct working fluid to different evaporator regions 203.

In the example shown in Fig. 2 the ducts 103 have a curved shape so that the ducts 103 curve downwards from the condenser 105 to the evaporator region 203. The condenser 105 is not shown in Fig. 2. In the example shown in Fig. 2 the ducts 103 are wider at the top than at the bottom so that the duct 103 is wider closer to the condenser 105 than at the evaporator region 203. The variation in the width of the duct 103 can help to control the flow of working fluid in the vapour chamber 101. Other shapes of the ducts 103 could be used in other examples of the disclosure.

The example array 201 of Fig. 2 comprises twenty ducts 103 that extend radially outwards from a central evaporator region 203. Having the ducts 103 extend radially outwards from the evaporator region 203 reduces the length of the ducts 103 that are required to provide the working fluid to the evaporator region 203. This minimizes the distance that the working fluid needs to travel. Other designs for the ducts 103 could be used in other examples of the disclosure. For instance, the shape of the vapor chamber 101 or the position of the other ducts 103 within the vapor chamber 101 could mean that it might not be possible to have all of the ducts extending radially outwards from an evaporator region 203. The number of ducts 103 and the size of the ducts 103 that are provided could depend upon the amount of heat that is to be transferred by the vapour chamber 101 and the volume of flow of working fluid required to enable this heat transfer.

In the example shown in Fig. 2 the twenty ducts 103 are spaced at regular angular intervals around the evaporator region 203. This can provide for even heat transfer from the evaporator region 203. In other examples the ducts 103 might not be provided at regular intervals. In other examples the angular spacing of the ducts 103 within an array 201 could be determined by factors such as the size and shape of the vapour chamber 101, the arrangements of the components that are to be cooled by the vapour chamber 101, the positions of other arrays 201 of ducts 103 within the vapour chamber 101 or by any other suitable factor.

In the example array 201 of Fig. 2 the ducts 103 have different lengths. In the example shown in Fig. 2 the ducts 103 have two different lengths. It is to be appreciated that other arrangements having different lengths could be used in other examples of the disclosure. This can enable the working fluid to be drawn into the ducts from different portions of a condenser 105. The length of the ducts 103 that are used can be determined by factors such as the size and shape of the vapour chamber 101, the arrangements of the components that are to be cooled by the vapour chamber 101, the positions of other arrays 201 of ducts 103 within the vapour chamber 101 or by any other suitable factor.

The array 201 of ducts 103 can provide a modular structure that can be fitted into a vapour chamber 101 in any suitable arrangement. For example, the position of the array 201 of ducts within a vapour chamber 101 can be selected to coincide with the positions of electronic components within an electronic device. This can enable the array 201 of ducts to be used to cool the electronic components. The size and shape of the array 201 can be easily modified by changing any of the size, shape, number or relative positions of the ducts 103 within the array 201. This enables the design of the arrays 201 to be adapted to improve heat transfer for a specific device or to fit in around other arrays 201 or other components or for any other purpose. For example, where different electronic devices have different components in different positions the vapour chambers 101 can easily be manufactured having arrays of ducts 201 in positions corresponding to the positions of electronic components.

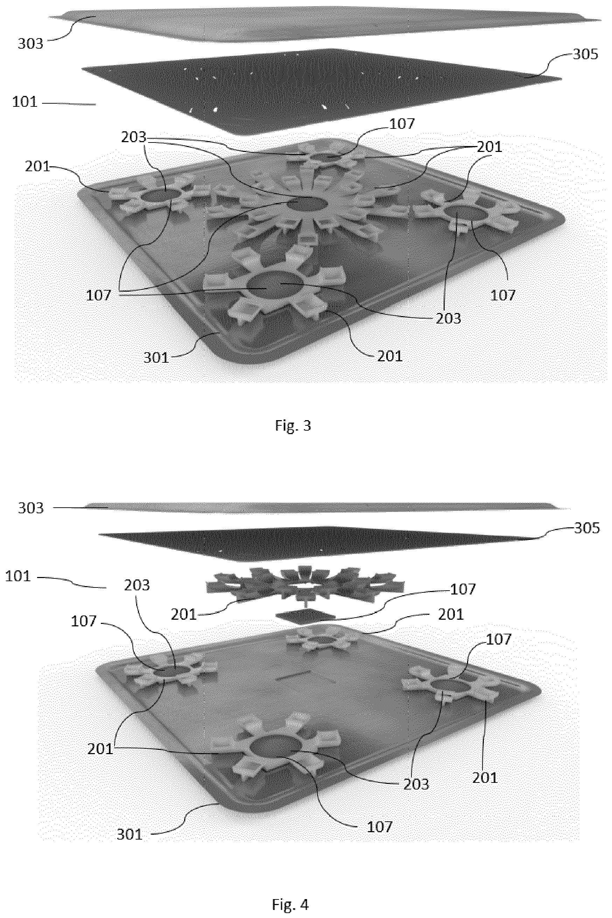

Figs. 3 and 4 show exploded views of the array 201 of ducts 103 provided within an example vapour chamber 101. The powder 109 is not shown in Figs. 3 and 4. It is to be appreciated that the powder 109 would be provided within the ducts 103. The powder 109 can be provided within the ducts 103 so that the powder 109 reaches an upper end of the ducts 103. The powder 109 can reach an upper end of the ducts 103 to enable the powder 109 within the ducts 103 to be coupled to a condenser 105 and enable working fluid to flow from the condenser 105 into the powder 109 in the ducts 103.

The vapour chamber 101 shown in Figs. 3 and 4 is a square vapour chamber 101. Other shapes of the vapour chamber 101 could be used in other examples of the disclosure. The shape of the vapour chamber could be determined by the shape of the device that the vapour chamber 101 is to be provided within and/or the positions of components that require cooling within the device.

The vapour chamber 101 comprises an upper wall 303 and a lower wall 301 that provide the outer surfaces of the vapour chamber 101. The walls 301, 303 can comprise a thin, lightweight layer that can enable heat to be transferred through the walls 301, 303. The walls 301, 303 can have a thickness of the region of 150 micrometers. The walls 301, 303 can comprise any suitable material such as copper or a very thin layer of plastic or any other material that can be configured to be thermally conductive. The very thin layer of plastic would need to be thin enough to enable heat to be transferred through it.

In the example shown in Figs. 3 and 4 five different arrays 201 of ducts 103 are provided in the vapour chamber 101. A large array 201 of ducts 103 is provided in the center of the vapour chamber 101 and four smaller arrays 201 of ducts 103 are provided in the corners of the vapour chamber 101. The large array 201 of ducts 103 is the same as the array 201 of ducts 103 shown in Fig. 2.

The smaller arrays 201 of ducts 103 are similar to the large array of ducts 103 in that they comprise a plurality of ducts 103 extending outwards from around an evaporator region 203. The smaller arrays 201 are smaller than the large array 201 in that they comprise a fewer number of ducts 103 and also that the ducts 103 have a smaller length. This causes the smaller arrays 201 of ducts to provide for a smaller volume of flow of working fluid. In the example of Figs. 3 and 4 each of the smaller arrays 201 of ducts 103 comprises six ducts 103 regularly spaced around the evaporator region 203.

It is to be appreciated that other arrangements of ducts 103 could be used in other examples of the disclosure.

The evaporators 107 are provided in the evaporator regions 203. The evaporators 107 are provided at the end of the ducts 103. The evaporators 107 can close the end of the ducts 103 so as to prevent powder 109 from spilling out of the end of the ducts 103. In the examples shown the arrays 201 comprise a plurality of ducts 103 around a single evaporator 107 so that a single evaporator 107 closes the ends of a plurality of ducts 103.

A condenser wick 305 is provided overlaying the plurality of arrays 201. In the examples of Figs. 3 and 4 a single condenser wick 305 is provided overlaying all of the arrays 201 within the vapour chamber 101. In other examples a plurality of condenser wicks 305 can be provided so that different condenser wicks 305 are provided for different arrays 201.

The condenser wick 305 can comprise a planar layer of wick structure that allows for transport of the working fluid in a liquid phase. The condenser wick 305 can comprise a sheet of material that can be formed by three dimensional printing or any other process that allows for small channels for flow of the working fluid to be formed.

In the examples of Figs. 3 and 4 the condenser wick 305 is provided over the upper ends of the ducts 103. This can enable the condenser wick 305 to act as a seal and prevent powder 109 from spilling out of the ducts 103.

When the ducts 103 are filled with powder 109 the powder 109 can be provided so that it overfills the ducts 103. When the condenser wick 305 is provided over the ducts 103 the condenser wick 305 then contacts the powder 109 rather than the walls of the ducts 103. This enables the powder 109 to be fluidically coupled to the condenser wick 305 and controls the flow of the working fluid from the condenser wick 305 into the powder 109.

As the powder 109 is compressible it can be pressed to fit around any type of condenser 105 of condenser wick 305. This can enable the ducts 103 filled with powder 109 to be fitted to any other suitable type of components of vapour chambers 101.

When the vapour chamber 101 is assembled the ducts 103 in the arrays 201 are filled with powder and the components of the vapour chamber 101 that are shown in the exploded views in Figs. 3 and 4 are sandwiched together and placed under a vacuum. This presses the condenser wick 305 into the powder 109 in the ducts 103 and provides a fluid path for the working fluid from the condenser wick 305 into the ducts 103.

In the example shown in Fig. 3 the ducts 103 filled with powder 109 can provide support structures for the vapour chamber 101 that help to maintain the spacing between the upper wall 303 and the lower wall 301. In other examples of the disclosure additional support structures could be provided within the vapour chamber 101 to help to maintain this spacing.

The arrays 201 of ducts 103 as shown in Figs. 2 to 4 provide for a modular system that enables different sized and shaped arrays to be assembled by using different sizes and shapes and arrangements of the ducts 103. The different arrays 201 can then be provided in different positions within the vapour chambers 101. For example, the positions of the arrays 201 of ducts 103 can be selected to correspond to the positions of the heat sources that are to be cooled by the vapour chamber 101. This can enable different vapour chambers 101 to be assembled for different types of devices. The different vapour chambers 101 can be easily adapted to provide for improved heat transfer in different devices of types of devices which can make the devices more energy efficient without increasing the costs of manufacturing the devices.

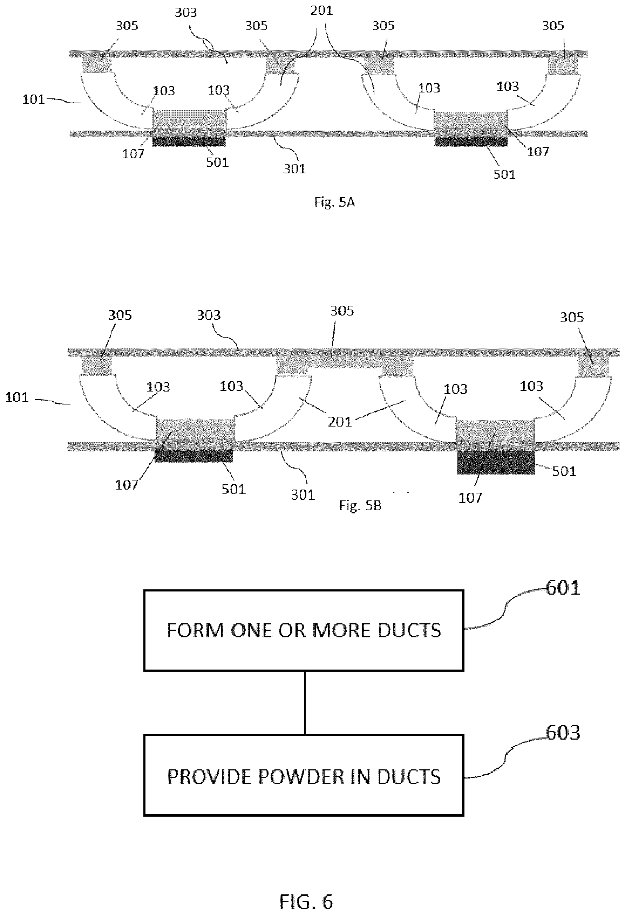

Figs. 5A and 5B show cross sections of example vapour chambers 101. The vapour chambers 101 comprise ducts 103 filled with powder 109 as described above. Corresponding reference numerals are used for corresponding features.

In the example shown in Fig. 5A the vapour chamber 101 comprises two arrays 201 of ducts 103. These can be configured to provide for heat transfer for two different heat sources 501. The heat sources 501 could be electronic components within a device or any other suitable type of heat source 501. The arrays 201 are positioned within the vapour chamber 101 so that the evaporators 107 are provided adjacent to the respective heat sources 501. For example, a first array 201 of ducts 103 can be configured to provide cooling for a first electronic component and a second array 201 of ducts 103 can be configured to provide cooling for a second electronic component.lt is to be appreciated that due to the modular nature of the vapour chamber 101 and the arrays 201 of ducts 103 the arrays 201 could be provided in different positions for different devices.

In the example of Fig. 5A a separate condenser wick 305 is provided for each of the arrays 201 of ducts 103. This restricts working fluid from flowing between the different arrays 201 of ducts 103 and can thermally isolate the different arrays 201 of ducts 103 from each other. This thermal isolation could enable different levels of cooling to be provided to the different heat sources 501. This could be useful, for example, if the device that is being cooled by the vapour chamber 101 has different components that have different sensitivities to temperature or generate different amounts of unwanted heat. For example, an optoelectronic component could be very sensitive to heat and could have a small tolerance for an operating temperature range while other components such as a processing unit could generate more heat but could have a higher tolerance of higher temperatures and so be less sensitive to heat. The example arrangement shown in Fig. 5A could enable such components to be thermally isolated from each other.

In the example shown in Fig. 5B the condenser wick 305 for each of the arrays 201 of ducts 103 is connected. This allows for working fluid to flow between the different arrays 201 of the 103. In this example the different arrays of ducts 103 are not thermally isolated from each other. This provides for a simpler configuration of the vapour chamber 101 and can enable the vapour chamber 101 to be fabricated from a smaller number of individual components.

Fig. 6 shows an example method that can be used to fabricate vapour chambers 101 according to examples of the disclosure. The method comprises at block 601 forming one or more ducts 103 configured to extend between a condenser 105 and an evaporator 107.

The one or more ducts 103 can be formed using any suitable process. The duct 103 that is formed comprises a hollow tube. In some examples the one or more ducts 103 can be formed using as additive manufacturing process such as three-dimensional printing. Other types of processes that can be used could be injection moulding, 5-axiz computer numerical controls (CNC) processes or any other suitable process. This provides for design freedom in the method of manufacturing that is used to form the ducts 103. This can enable the ducts 103 to be formed quickly and/or cheaply.

At block 603 the method comprises providing powder 109 within the one or more ducts 103 wherein the powder 109 is configured to control flow of a working fluid through the one or more ducts 103.

The grain size of the powder 109 is selected so as to control the flow of working fluid through the one or more ducts 103. In some examples the grain size of the powder and any variation in grain size of the powder 109 can be selected based on the expected use of the duct 103. For instance a duct 103 that is intended to be positioned next to a component that generates a larger amount of excess heat could have a grain size that enables a larger flow of working fluid compared to a duct 103 that is intended to be positioned next to a component that generates a smaller amount of heat.

The use of the powder 109 provides design freedom in the porosity of the ducts 103 that can easily be controlled through the selection of the grain sizes and density of packing of the powder 109. This can enable the ducts 103 to be fabricated so as to provide fluid flow optimised for the intended use of the vapor chamber 101.

When the powder 109 is provided in the duct 103 the powder 109 can be provided to an upper end of the duct 103 so that the powder 103 fills the duct 103. In some examples the powder 109 could be provided so that it overfills the ducts 103. This can mean that the powder 109 extends above the end of the duct 103. This can enable the powder 109 to be fluidically coupled to other components of the vapor chamber 101 such as the condenser wick 305.

Once the duct 103 has been filled with powder 109 the duct 103 can be provided in a vapour chamber 101. In some examples a condenser wick 305 can be positioned over the ducts 103 that have been filled with powder 109. The condenser wick 305 can be pressed into the powder 109 at the end of the duct 103 so as to enable working fluid to flow from the condenser wick 305 into the powder 109 in the duct 103. This enables the powder 109 to be fluidically coupled to other components of the vapor chamber 101.

A plurality of the ducts 103 can be configured to form an array 201 of ducts 103. The array 201 can be centred around an evaporator region 203. The array 201 can form a module that can be positioned in any suitable position within the vapour chamber 101. This can allow the positions of the arrays 201 of ducts 103 to be selected to correspond with electronic components or other heat sources. The ducts 103 can be formed to provide any suitable size or shape array 201 of ducts 103.

Examples of the disclosure therefore provide for a vapour chamber 101 that can be made simply without the need for complex processes such as three dimensional printing. The vapour chamber 101 can comprises modular components such as arrays 201 of ducts 103 that can be positioned in any suitable position within the vapour chamber 101. This provides a simple way of providing for design freedom and so can enable energy efficient energy transfer devices to be provided in a cost effective manner.

Also, the fluid flow through the ducts 103 can be controlled by controlling the grain size of the powder 109 that is used. This can enable the heat transfer properties to be easily controlled and allows for efficient systems to be easily designed and manufactured without any complex manufacturing processes.

Examples of the disclosure could be provided in any suitable type so devices. In some examples the vapour chambers 101 could be provided within consumer electronic devices such as mobile phones or smart speakers. However, it is to be appreciated that the vapour chambers 101 are not limited to such devices and could be used in other technologies such as vehicles, satellites, data centres or any other suitable devices which require cooling.

The term 'comprise' is used in this document with an inclusive not an exclusive meaning. That is any reference to X comprising Y indicates that X may comprise only one Y or may comprise more than one Y. If it is intended to use 'comprise' with an exclusive meaning then it will be made clear in the context by referring to "comprising only one..." or by using "consisting".

In this description, reference has been made to various examples. The description of features or functions in relation to an example indicates that those features or functions are present in that example. The use of the term 'example' or 'for example' or 'can' or 'may' in the text denotes, whether explicitly stated or not, that such features or functions are present in at least the described example, whether described as an example or not, and that they can be, but are not necessarily, present in some of or all other examples. Thus 'example', 'for example', 'can' or 'may' refers to a particular instance in a class of examples. A property of the instance can be a property of only that instance or a property of the class or a property of a sub-class of the class that includes some but not all of the instances in the class. It is therefore implicitly disclosed that a feature described with reference to one example but not with reference to another example, can where possible be used in that other example as part of a working combination but does not necessarily have to be used in that other example.

Although examples have been described in the preceding paragraphs with reference to various examples, it should be appreciated that modifications to the examples given can be made without departing from the scope of the claims.

Features described in the preceding description may be used in combinations other than the combinations explicitly described above.

Although functions have been described with reference to certain features, those functions may be performable by other features whether described or not.

Although features have been described with reference to certain examples, those features may also be present in other examples whether described or not.

The term 'a' or 'the' is used in this document with an inclusive not an exclusive meaning. That is any reference to X comprising a/the Y indicates that X may comprise only one Y or may comprise more than one Y unless the context clearly indicates the contrary. If it is intended to use 'a' or 'the' with an exclusive meaning then it will be made clear in the context. In some circumstances the use of 'at least one' or 'one or more' may be used to emphasis an inclusive meaning but the absence of these terms should not be taken to infer any exclusive meaning.

The presence of a feature (or combination of features) in a claim is a reference to that feature or (combination of features) itself and also to features that achieve substantially the same technical effect (equivalent features). The equivalent features include, for example, features that are variants and achieve substantially the same result in substantially the same way. The equivalent features include, for example, features that perform substantially the same function, in substantially the same way to achieve substantially the same result.

In this description, reference has been made to various examples using adjectives or adjectival phrases to describe characteristics of the examples. Such a description of a characteristic in relation to an example indicates that the characteristic is present in some examples exactly as described and is present in other examples substantially as described.

Whilst endeavoring in the foregoing specification to draw attention to those features believed to be of importance it should be understood that the Applicant may seek protection via the claims in respect of any patentable feature or combination of features hereinbefore referred to and/or shown in the drawings whether or not emphasis has been placed thereon.

## Claims

1. A vapour chamber comprising:
one or more ducts extending between a condenser and an evaporator; and
powder provided within the one or more ducts wherein the powder is configured to control flow of a working fluid through the one or more ducts.

2. A vapour chamber as claimed in claim 1 comprising an evaporator at a first end of the one or more ducts and a condenser at a second end of the one or more ducts.

3. A vapour chamber as claimed in any preceding claim wherein a grain size of the powder is selected to control flow of the working fluid through the one or more ducts.

4. A vapour chamber as claimed in any preceding claim wherein different grain sizes of powder are used at different positions within the one or more ducts to control flow of the working fluid through the one or more ducts.

5. A vapour chamber as claimed in any preceding claim wherein a grain size of the powder within the one or more ducts is configured to balance fluid resistance within the one or more ducts with capillary pressure within an evaporator.

6. A vapour chamber as claimed in any preceding claim comprising a plurality of ducts wherein powder is provided within the ducts and the plurality of ducts are configured to extend outward from an evaporator.

7. A vapour chamber as claimed in any preceding claim wherein the powder is provided within the one or more ducts so that the powder reaches an upper end of the one or more ducts.

8. A vapour chamber as claimed in claim 7 wherein the powder reaches an upper end of the one or more ducts to enable the powder within the one or more ducts to be coupled to a condenser to enable working fluid to flow from the condenser to the powder in the one or more ducts.

9. A vapour chamber as claimed in any preceding claim wherein the vapour chamber comprises a first array of one or more ducts that is thermally coupled to a second array of one or more ducts.

10. A vapour chamber as claimed in any preceding claim wherein the vapour chamber comprises a first array of one of more ducts that is thermally isolated from a second array of one or more ducts.

11. A vapour chamber as claimed in any of claims 9 to 10 wherein the first array of one or more ducts is configured to provide cooling for a first electronic component and the second array of one or more ducts is configured to provide cooling for a second electronic component.

12. An electronic device comprising a vapour chamber as claimed in any preceding claim.

13. A method of forming a vapour chamber comprising;
forming one or more ducts configured to extend between a condenser and an evaporator; and
providing powder within the one or more duct wherein the powder is configured to control flow of a working fluid through the one or more ducts.

14. A method as claimed in claim 13 wherein the one or more ducts is formed using an additive manufacturing process.

15. A method as claimed in any of claims 14 to 15 wherein the powder is provided up to an upper end of the one or more ducts and the method also comprises positioning a condenser over the one or more ducts wherein the positioning is configured to enable working fluid to flow from the condenser layer into the powder in the one or more ducts.
